**Europäisches Patentamt**

**European Patent Office**

**Office européen des brevets**

(19)

(11) Numéro de publication : **0 286 472 B1**

(12)
# FASCICULE DE BREVET EUROPEEN

(45) Date de publication du fascicule du brevet :
**22.01.92 Bulletin 92/04**

(51) Int. Cl.⁵ : **C30B 23/06,** C23C 14/30, H01J 37/305

(21) Numéro de dépôt : **88400590.1**

(22) Date de dépôt : **11.03.88**

(54) **Dispositif pour l'évaporation sous vide de matériaux.**

(30) Priorité : **13.03.87 FR 8703483**

(43) Date de publication de la demande :
**12.10.88 Bulletin 88/41**

(45) Mention de la délivrance du brevet :
**22.01.92 Bulletin 92/04**

(84) Etats contractants désignés :
**DE FR GB IT NL**

(56) Documents cités :
**EP-A- 0 121 818
US-A- 3 454 814
JOURNAL OF VACCUM SCIENCE AND TECH-
NOLOGY A, vol. 3, no. 4, juillet à août 1985,
pages 1885,1886, Woodbury, US; M. HEIBLUM
et al.: "Electron-gun evaporators of refractory
metals compatible with molecular beam epitaxy"**

(73) Titulaire : **ETAT FRANCAIS représenté par le Ministre Délégué des Postes et Télécommunications
(CENTRE NATIONAL D'ETUDES DES TELECOMMUNICATIONS) 38-40 rue du Général Leclerc
F-92131 Issy-les-Moulineaux (FR)**

(72) Inventeur : **Arnaud D'Avitaya, François
11, avenue du Vercors
38240 Meylan (FR)**

(74) Mandataire : **Plaçais, Jean-Yves et al
Cabinet Netter, 40, rue Vignon
F-75009 Paris (FR)**

EP 0 286 472 B1

Jouve, 18, rue Saint-Denis, 75001 PARIS

**Description**

L'invention concerne un dispositif pour l'évaporation sous vide de matériaux. Elle trouve une application dans la fabrication de matériaux semi-conducteurs. Plus particulièrement, elle s'applique à l'épitaxie de matériaux semi-conducteurs et/ou dopants par jets moléculaires.

Le principe connu de l'épitaxie de matériaux par jets moléculaires est le suivant : chacun des matériaux semi-conducteurs et dopants que l'on veut déposer sur un substrat pour réaliser un composé semi-conducteur est contenu dans un creuset que l'on chauffe sous vide. Les atomes s'évaporent de la surface des matériaux chauffés et se déplacent par jets dans le vide jusqu'à la surface du substrat où ils se déposent. Le mélange est réglé par le flux d'atomes vers le substrat en augmentant ou en abaissant la température des creusets.

On connaît actuellement deux moyens pour chauffer sous vide les matériaux semi-conducteurs et dopants au-dessus de leur point de fusion : le canon à électrons et la cellule d'évaporation à rayonnement infrarouge.

Le principe de chauffage au moyen d'un canon à électrons est le suivant : on place un creuset sensiblement dans le même plan qu'un filament qui émet à haute température des électrons. Un champ magnétique créé par des bobines électromagnétiques canalise les électrons pour les concentrer sur le creuset. Le filament est porté à un potentiel électrique négatif élevé par rapport à la masse tandis que le creuset est à la masse.

Le principe de chauffage au moyen d'une cellule d'évaporation à rayonnement infrarouge est le suivant : on place sensiblement au centre d'une cellule cylindrique formée d'écrans thermiques, un creuset entouré d'un filament spiralé. Le filament chauffé par effet Joule émet un rayonnement infrarouge dans toute la cellule et porte ainsi le creuset à une température de l'ordre de 600°C à 1200°C maximum.

Généralement, les matériaux tels que le silicium, le cobalt, le nickel, ... etc, sont évaporés au moyen d'un canon électronique car leur évaporation nécessite une température élevée que peut fournir un tel moyen. En ce qui concerne les matériaux dopants, l'homme de l'art leur préfère la cellule d'évaporation à rayonnement infrarouge car elle permet d'obtenir grâce à la stabilité de son flux d'évaporation, des couches de matériaux d'épaisseur uniforme et à dopage constant. Ceci est particulièrement vrai pour les dopants de type n et pour les dopants de type p tels que le gallium. Cependant, étant donné les problèmes qu'entraîne le dopage par le gallium, l'homme de l'art préfère le bore en tant que dopant. Malheureusement, l'évaporation du bore requiert de travailler à une température de l'ordre de 2000°C que ne peut fournir une cellule d'évaporation à rayonnement infrarouge. Il a été envisagé d'évaporer le bore au moyen d'un canon électronique, néanmoins cette solution n'est pas satisfaisante en raison du peu de stabilité de flux d'évaporation de ce moyen de chauffage.

On connait par ailleurs (Heiblum et al., Journal of Vacuum Science & Technology, A, Vol. 3, n° 4, juillet-août 1985, pages 1885-1886; US-A-3454 814) des dispositifs pour l'évaporation sous vide de matériaux par l'application d'un champ électrique focalisant sur le creuset les électrons émis par un filament entourant ledit creuset.

Ces dispositifs connus ne donnent pas entière satisfaction, notamment lorsqu'il s'agit d'atteindre une température élevée, tout en conservant une stabilité et une pureté du flux d'évaporation qui autorise l'évaporation des dopants aussi bien que des composants principaux des couches semi-conductrices. En effet, le matériau à évaporer reçoit directement le bombardement d'électrons. Ceci présente les inconvénients suivants :

– il n'est pas possible d'interposer une paroi étanche entre le filament émettant les électrons et la chambre de réaction. Par conséquent, le matériau du filament vient polluer la chambre de réaction;

– dans ces systèmes antérieurs, les électrons sont réémis depuis le matériau bombardé et se propagent dans la chambre, provoquant des charges sur les pièces à traiter et provoquant des dissociations de molécules dans le gaz réactif, ce qui crée des espèces chimiques indésirables;

– on ne peut pas disposer une sonde de mesure de température (polluante) dans le matériau à évaporer.

L'invention va, en ses différents aspects, porter remède à ces inconvénients.

Très généralement, elle utilise des moyens de focalisation à haute tension pour appliquer les électrons de chauffage sur la paroi du creuset.

Il est donc prévu un dispositif pour l'évaporation sous vide de matériaux, comprenant une cellule cylindrique logeant de façon étanche et sensiblement au centre de sa partie supérieure un creuset conducteur de l'électricité contenant lesdits matériaux, entouré par au moins un filament de chauffage, conducteur de l'électricité, propre à émettre à haute température des électrons, la cellule comprenant encore des moyens de chauffage du filament et des moyens de focalisation des électrons propres à engendrer un champ électrique élevé entre le filament et le creuset.

Selon un aspect de l'invention, les moyens de focalisation comprennent un ensemble d'écrans rapprochés disposés à l'intérieur de la cellule, entourant le creuset en regard de ses faces latérales et de sa base, ainsi qu'une partie au moins du filament, et soumis à un premier potentiel électrique négatif par rapport à la masse pour focaliser sur la paroi du creuset les électrons émis par le filament.

De préférence, le creuset est mis à la masse.

Selon un autre aspect de l'invention, le dispositif comporte en outre un ensemble d'écrans distants placés à l'opposé du creuset par rapport à l'ensemble d'écrans rapprochés, isolés de ceux-ci, et mis à la masse.

Selon un mode de réalisation préféré du dispositif de l'invention, l'ensemble d'écrans rapprochés comprend une première pluralité d'écrans superposés, appliqués sur la face interne de la cellule et disposés en regard des faces latérales du creuset, ainsi qu'une seconde pluralité d'écrans superposés, fixés au centre de la cellule, et disposés en regard de la base du creuset, tandis que l'ensemble d'écrans distants comprend une troisième pluralité d'écrans superposés, fixés au centre de la cellule et disposés en dessous de la deuxième pluralité d'écrans.

Selon encore une autre caractéristique de l'invention, les moyens de focalisation comprennent des moyens générateurs pour appliquer au filament un second potentiel électrique négatif par rapport à la masse.

De préférence ces moyens générateurs permettent de porter, le second potentiel électrique du filament a une valeur de -1 KV environ.

Avantageusement le dispositif comprend des moyens permettant d'égaliser sensiblement, les premier et second potentiels.

Selon un mode de réalisation préféré du dispositif de l'invention, le filament est recourbé dans sa partie centrale pour former un coude et une potence est placée autour du coude pour maintenir le filament sensiblement vertical.

Selon un aspect de l'invention, le matériau constituant le creuset a une pression de vapeur très basse à haute température.

De préférence, le matériau constituant le creuset est du graphite.

Selon un mode de réalisation préféré du dispositif de l'invention, la cellule comprend en outre des moyens de régulation aptes à mesurer la température du matériau contenu dans le creuset et aptes à agir sur les moyens de chauffage du filament pour réguler ladite température.

Selon un autre aspect de l'invention, les moyens de régulation comprennent au moins un thermocouple fixé sur la base du creuset et relié à des moyens électriques agissant sur les moyens de chauffage du filament pour réguler la température.

En pratique, la partie inférieure de la cellule est constituée d'une première pièce supportant la première pluralité d'écrans et sur laquelle est fixée une tige maintenant le creuset sensiblement au centre de la partie supérieure de la cellule, une deuxième pièce, accolée à la première, servant d'embase à la cellule, les amenées de potentiel des moyens générateurs, les années de courant des moyens de chauffage du filament et le thermocouple traversant respectivement lesdites pièces par des passages isolés électriquement, une troisième pièce reliée à la seconde pièce par deux colonnes et sur laquelle sont montés des moyens pour compenser la dilatation du thermocouple, et une bride étanche destinée à raccorder la cellule à une enceinte sous vide et au-delà de laquelle sont installés les moyens générateurs de potentiel, les moyens de chauffage du filament et les moyens de régulation.

L'invention apparaîtra mieux à la lecture de la description qui va suivre, d'exemples de réalisations donnés à titre purement illustratif et nullement limitatif. On se réfère aux dessins sur lesquels :

– la figure 1 représente schématiquement un mode de réalisation particulier du dispositif objet de l'invention;

– la figure 2 représente schématiquement un exemple de réalisation d'un filament selon l'invention; et

– la figure 3 représente schématiquement la régulation de température de la cellule objet de l'invention.

Les dessins annexés comportent à de nombreux titres des informations de caractère certain. En conséquence, ils pourront non seulement permettre de comprendre la description détaillée ci-après, mais aussi contribuer à la définition de l'invention, le cas échéant.

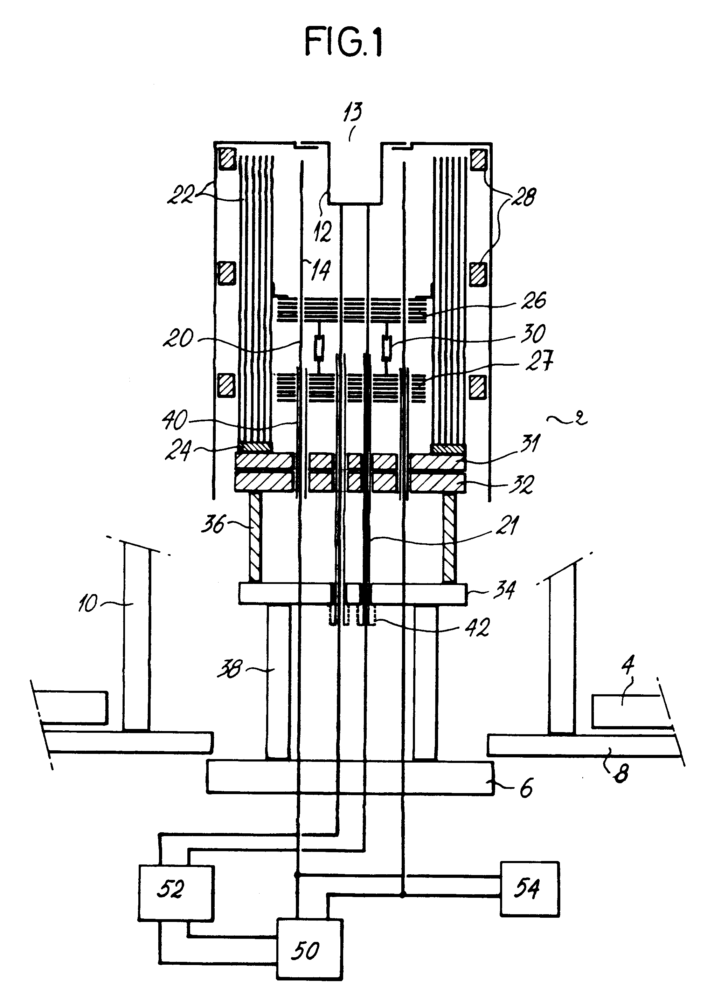

On a représenté sur la figure 1 une vue schématique d'un mode particulier du dispositif objet de l'invention comprenant une cellule 2 de forme cylindrique de révolution.

La cellule 2 est placée à l'intérieur d'une enceinte 4 par l'intermédiaire d'une bride étanche 6 faisant partie intégrante de la cellule et venant se raccorder à la bride étanche 8 de l'enceinte 4. Le vide régnant dans l'enceinte 4 est du domaine de l'ultra-vide, c'est-à-dire des pressions de l'ordre de $10^{-7}$ à $10^{-9}$ Pascal. La cellule 2 peut être encadrée par des panneaux cryogéniques 10 fixés sur la paroi interne de l'enceinte 4.

La partie supérieure de la cellule 2 loge en son centre un creuset 12 conducteur de l'électricité contenant un matériau que l'on veut déposer sur un substrat (non représenté) placé dans l'enceinte à vide 4 en regard de l'orifice 13 du creuset 12.

Le matériau constituant le creuset 12 a une pression de vapeur très basse à haute température; il peut être par exemple du graphite.

Le creuset 12 est entouré d'au moins un filament de chauffage alimenté en courant par des moyens de chauffage placés au-delà de la bride 6 de la cellule 2. Les filaments 14 sont conducteurs de l'électricité et propres à émettre à haute température des électrons. Sur la figure 1, on a représenté deux filaments 14.

Selon un mode de réalisation préféré de l'invention, le creuset 12 est mis à la masse.

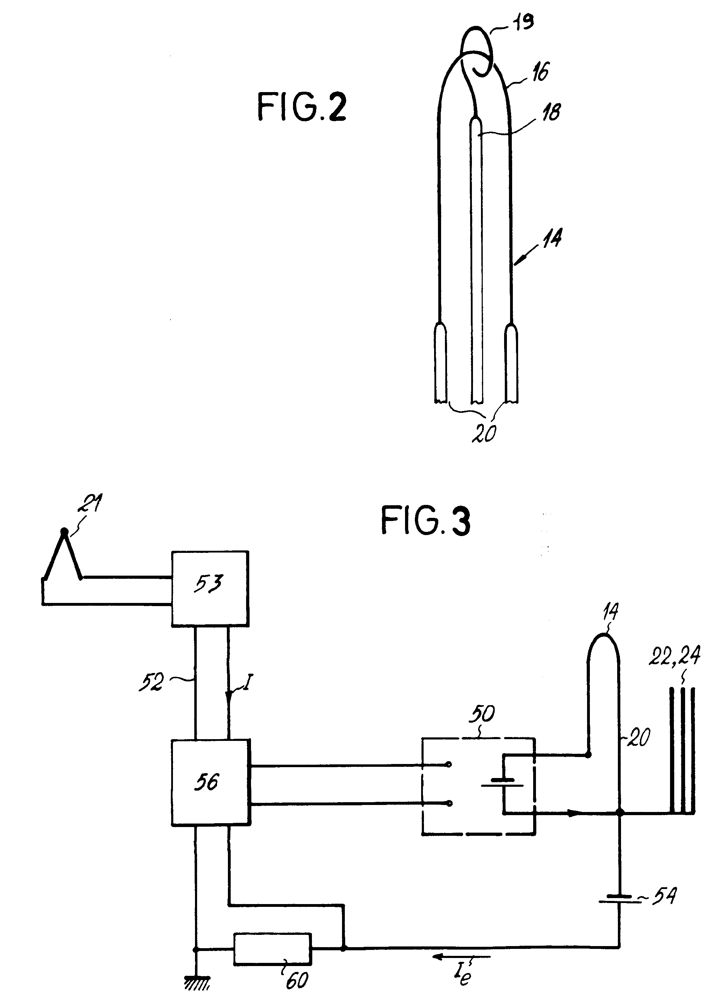

En se référant à la figure 2, qui représente schématiquement un exemple de réalisation d'un filament 14, on voit que la partie centrale du filament 14 est recourbée pour former un coude. Une potence 18 est intercalée entre les amenées de courant électrique 20. L'extrémité libre 19 de la potence 18 est placée autour du coude 16. La potence 18 permet de maintenir le filament 14 vertical et d'éviter qu'il vienne en contact électrique avec le creuset et les écrans thermiques que l'on décrira ci-après.

Le matériau constituant la potence 18 est de préférence du molybdène. Les filaments 14 ainsi recourbés ont une bonne tenue mécanique et leur remplacement, s'ils sont cassés, est aisé. Le matériau constituant les filaments 14 est du tungstène.

Pour engendrer un champ électrique élevé entre les filaments 14 et le creuset, les filaments 14 sont portés à un potentiel électrique négatif par rapport à la masse par l'intermédiaire de moyens générateurs de potentiel placés au-delà de la bride 6 de la cellule 2. Le potentiel des filaments a une valeur de -1 KV environ.

En se référant à nouveau à la figure 1, on voit que la cellule 2 comprend ensuite une première pluralité d'écrans thermiques 22 superposés, verticaux, appliqués sur la face interne de la cellule 2 sur toute sa hauteur et disposés en regard des faces latérales du creuset 12.

Le matériau constituant les écrans 22 est du tantale par exemple. Ils sont au nombre de sept, par exemple. Les six premiers écrans sont solidaires d'une bague 24 en tantale disposée dans la partie inférieure de la cellule que l'on décrira ci-après, de manière que le démontage de la cellule soit facilité.

Le dernier des sept écrans 22 est à la masse et isolé des six premiers par des plots isolants 28 constitués d'un matériau tel que le nitrure de bore pyrolytique.

Pour focaliser les électrons émis par les filaments 14 sur le creuset 12, les écrans 22 sont soumis à un potentiel électrique négatif ayant une valeur de -1 KV environ.

La cellule 2 comprend encore une seconde pluralité d'écrans thermiques 26 superposés, horizontaux, fixés au centre de la cellule et disposés en regard de la base du creuset 12.

Pour repousser les électrons sur la base du creuset, les écrans 26 sont en contact électrique avec les six premiers écrans 22 et sont ainsi portés à un potentiel électrique négatif d'une valeur de -1 KV environ. Le matériau constituant les écrans 26 est du tantale. Les écrans 26 sont au nombre de sept par exemple.

La cellule comprend enfin une troisième pluralité d'écrans thermiques 27 superposés, horizontaux, fixés au centre de la cellule et disposés en dessous de la deuxième pluralité d'écrans 26. Les écrans 27 sont à la masse et isolés des écrans 26 par des tiges 30 constituées d'un matériau isolant tel que l'alumine. Le matériau constituant les écrans 27 est du tantale.

La cellule 2 comprend en outre des moyens de régulation aptes à mesurer la température du matériau contenu dans le creuset et aptes à agir sur les moyens de chauffage du filament pour réguler ladite température.

Les moyens de régulation comprennent au moins un thermocouple 21 fixé sur la base du creuset. Le thermocouple 21 est constitué d'un premier fil en tungstène et d'un second fil en tungstène-rhénium.

La partie inférieure de la cellule 2 est constituée d'une première pièce 31 supportant la bague 24 qui sert d'appui aux écrans verticaux 22. Sur la face extérieure de la pièce 31 est fixée une tige portée à la masse et maintenant le creuset 12 sensiblement au centre de la partie supérieure de la cellule.

Le matériau constituant la pièce 31 est de l'alumine par exemple. Une seconde pièce 32, accolée à la première 31, sert d'embase à la cellule. Le matériau constituant cette embase 31 est du molybdène.

Les amenées de potentiel des moyens générateurs de potentiel, les amenées de courant des moyens de chauffage de filament et le thermocouple 21 passent à travers les deux pièces 31 et 32 par des passages 40 isolés électriquement. Par exemple, ces passages sont recouverts d'une bague en alumine.

La partie inférieure de la cellule 2 est constituée ensuite d'une troisième pièce 34 reliée à la seconde pièce 32 par deux colonnes 36 en molybdène. Des moyens 42 sont montés sur la troisième pièce 34 pour compenser la dilatation du thermocouple. Ces moyens 42 consistent à tendre le thermocouple 21 par un système de ressorts. La dilatation due à l'élévation de température à l'intérieur de la cellule est continuellement compensée de manière à éviter tout court-circuit des fils thermocouples non isolés avec les écrans 26 polarisés.

Le matériau constituant la troisième pièce est de l'acier inoxydable. Deux colonnes 38 en acier inoxydable relient la troisième pièce 34 à la bride étanche 6 de la cellule 2.

Les amenées de potentiel, les amenées de courant et le thermocouple 21 passent à travers la bride étanche 6 au moyen de passages étanches et sont reliés respectivement aux moyens générateurs de potentiel 54, aux moyens de chauffage de filament 50 et aux circuits électriques de régulation de température 52.

On se réfère maintenant à la figure 3 qui illustre schématiquement la régulation en température de la cellule conformément à l'invention.

Les moyens de chauffage 50 sont constitués d'une alimentation en courant pour chauffer le filament 14. Les moyens 50 sont reliés au filament 14 par l'intermédiaire d'amenées de courant 20.

Les moyens générateurs de potentiel 54 sont constitués d'une alimentation haute tension délivrant un potentiel électrique négatif de -1 KV apte à délivrer le courant d'émission $I_e$. Les moyens 54 sont reliés au filament 14 et aux écrans 22 et 26 par l'intermédiaire d'amenées de potentiel.

Le thermocouple 21 mesure la température de la cellule 2. Le thermocouple 21 est relié au circuit 52 agissant sur le courant d'émission $I_e$ pour réguler la température régnant dans la cellule.

Les circuits électriques de régulation 52 sont constitués d'un premier régulateur 53 à action proportionnelle, intégrale et dérivée usuellement appelé PID, et d'un second régulateur 56 également de type PID. Le régulateur 53 régule la température régnant dans la cellule 2, il est couplé au régulateur 56 qui compare le courant d'émission $I_e$ mesuré à travers la résistance 60 à la valeur de consigne dudit régulateur 56.

La régulation de la température de la cellule fonctionne de la façon suivante.

Le premier régulateur 53 compare la valeur de la température de consigne affichée par l'utilisateur à la valeur de la température mesurée par le thermocouple 21. Le circuit de régulation 52 agit suivant une fonction mathématique de type PID sur le signal de réglage I qui positionne le second régulateur 56 pour qu'il annule l'écart entre la valeur de la température mesurée et la valeur de consigne du régulateur 53. Le régulateur 56 annule cet écart en comparant sa valeur de consigne à la tension prise aux bornes de la résistance 60 et qui est proportionnelle au courant $I_e$. Après un calcul mathématique de type PID, le second régulateur 56 délivre une tension commandant le chauffage du filament 14 via l'alimentation de chauffage des filaments 50 afin de réguler la température de la cellule selon l'invention.

**Revendications**

1. Dispositif pour l'évaporation sous vide de matériaux, comprenant une cellule cylindrique (2) logeant de façon étanche et sensiblement au centre de sa partie supérieure un creuset (12) conducteur de l'électricité contenant lesdits matériaux, entouré par au moins un filament (14) de chauffage, conducteur de l'électricité, propre à émettre à haute température des électrons, la cellule (2) comprenant encore des moyens (50) de chauffage du filament et des moyens de focalisation des électrons propres à engendrer un champ électrique élevé entre le filament et le creuset, caractérisé en ce que les moyens de focalisation comprennent un ensemble d'écrans rapprochés (22,26) disposés à l'intérieur de la cellule, entourant le creuset (12) en regard de ses faces latérales et de sa base, ainsi qu'une partie au moins du filament, et soumis à un premier potentiel électrique négatif par rapport à la masse pour focaliser sur la paroi du creuset (12) les électrons émis par le filament (14).

2. Dispositif selon la revendication 1, caractérisé en ce que le creuset (12) est mis à la masse.

3. Dispositif selon l'une des revendications 1 et 2, caractérisé en ce qu'il comporte en outre un ensemble d'écrans distants (27) placés à l'opposé du creuset par rapport à l'ensemble d'écrans rapprochés (22,26), isolés de ceux-ci, et mis à la masse.

4. Dispositif selon la revendication 3, caractérisé en ce que l'ensemble d'écrans rapprochés comprend une première pluralité d'écrans (22) superposés, appliqués sur la face interne de la cellule (2) et disposés en regard des faces latérales du creuset (12), ainsi qu'une seconde pluralité d'écrans (26) superposés, fixés au centre de la cellule (2), et disposés en regard de la base du creuset (12), tandis que l'ensemble d'écrans distants comprend une troisième pluralité d'écrans (27) superposés, fixés au centre de la cellule (2), et disposés en dessous de la deuxième pluralité d'écrans (26).

5. Dispositif selon l'une des revendications précédentes, caractérisé en ce que les moyens de focalisation comprennent des moyens générateurs (54) pour appliquer au filament un second potentiel électrique négatif par rapport à la masse.

6. Dispositif selon la revendication 5, caractérisé en ce que les moyens générateurs (54) permettent de porter le second potentiel électrique du filament (14) a une valeur de -1 KV environ.

7. Dispositif selon la revendication 5, caractérisé en ce qu'il comprend des moyens permettant d'égaliser sensiblement les premier et second potentiels.

8. Dispositif selon l'une quelconque des revendications précédentes, caractérisé en ce que le filament (14) est recourbé dans sa partie centrale pour former un coude (16) et qu'une potence (18) est placé autour du coude (16) pour maintenir le filament (14) sensiblement vertical.

9. Dispositif selon l'une quelconque des revendications précédentes, caractérisé en ce que le matériau constituant le creuset (12) a une pression de vapeur très basse à haute température.

10. Dispositif selon la revendication 9, caractérisé en ce que le matériau constituant le creuset (12) est du graphite.

11. Dispositif selon l'une quelconque des revendications précédentes, caractérisé en ce que la cellule (2) comprend en outre des moyens de régulation aptes à mesurer la température du matériau contenu dans le creuset et aptes à agir sur les moyens de chauffage (50) du filament pour réguler ladite température.

12. Dispositif selon la revendication 11, caractérisé en ce que les moyens de régulation comprennent au moins un thermocouple (21) fixé sur la base du creuset (12) et relié à des moyens électriques (52) agissant sur les moyens de chauffage (50) du filament pour réguler la température.

13. Dispositif selon l'une quelconque des revendications précédentes, caractérisé en ce que la partie inférieure de la cellule (2) est constituée d'une première pièce (31) supportant la première pluralité d'écrans (22) et sur laquelle est fixée une tige maintenant le creuset (12) sensiblement au centre de la partie supérieure de la cellule, une deuxième pièce (32) accolée à la première (31) servant d'embase à la cellule (2), les amenées de potentiel des moyens générateurs (54), les amenées de courant (20) des moyens de chauffage (50) du filament (14) et le thermocouple (21) traversant respectivement lesdites pièces (31,32) par des passages isolés électriquement, une troisième pièce (34) reliée à la seconde pièce par deux colonnes (36) et sur laquelle sont montés des moyens (42) pour compenser la dilatation du thermocouple (21), et une bride (6) étanche destinée à raccorder la cellule (2) à une enceinte (4) sous vide et au-delà de laquelle sont installés les moyens générateurs (54), les moyens de chauffage (50) de filament et les circuits électriques (52) de régulation.

**Patentansprüche**

1. Anlage zur Vakuumverdampfung von Werkstoffen, umfassend eine zylindrische Zelle (2), in der abgedichtet und im wesentlichen mittig im oberen Teil ein die Werkstoffe aufnehmender, elektrisch leitender Tiegel (12) untergebracht ist, der von wenigstens einem elektrisch leitenden Heizdraht (14) zur Ausstrahlung einer hohen Elektronentemperatur umgeben ist, und die weiterhin Heizeinrichtungen (50) des Drahtes und Einrichtungen zur Fokussierung der Elektronen umfaßt, die dazu geeignet sind, ein elektrisches Feld zu erzeugen, das zwischen dem Draht und der Zelle errichtet ist, **dadurch gekennzeichnet,** daß die Einrichtungen zur Fokussierung eine Gruppe von benachbarten Abschirmungen (22, 26) aufweisen, die im Inneren der Zelle angeordnet, die Seitenwandung und den Boden des Tiegels (12) sowie wenigstens einen Teil des Drahtes umgibt und einem ersten elektrisch negativen Potential bezüglich der Masse unterworfen ist, um die durch den Draht (14) ausgestrahlten Elektronen auf die Seitenwandung des Tiegels (12) zu fokussieren.

2. Anlage nach Anspruch 1, **dadurch gekennzeichnet,** daß der Tiegel (12) an Masse gelegt ist.

3. Anlage nach einem der Ansprüche 1 und 2, **gekennzeichnet durch** eine Gruppe von entfernten Abschirmungen (27), die dem Tiegel bezüglich der Gruppe der benachbarten Abschirmungen (22, 26) gegenüberliegend angeordnet, von dieser isoliert und an Masse gelegt ist.

4. Anlage nach Anspruch 3, **dadurch gekennzeichnet,** daß die Gruppe der benachbarten Abschirmungen eine erste Vielzahl von geschichteten, an der inneren Stirnseite der Zelle (2) befestigten und zu den Seitenwandungen des Tiegels (12) hin angeordneten Abschirmungen (22) sowie eine zweite Vielzahl von geschichteten, in der Mitte der Zelle (2) befestigten und zum Boden des Tiegels (12) hin angeordneten Abschirmungen (26) umfaßt, und daß die Gruppe von entfernten Abschirmungen eine dritte Vielzahl von geschichteten, in der Mitte der Zelle (2) befestigten und unterhalb der zweiten Vielzahl von Abschirmungen (26) angeordneten Abschirmungen (27) umfaßt.

5. Anlage nach einem der vorhergehenden Ansprüche, **dadurch gekennzeichnet,** daß die Einrichtungen zur Fokussierung Erzeugungseinrichtungen (54) umfassen, um den Draht mit einem zweiten elektrisch negativen Potential bezüglich der Masse zu beaufschlagen.

6. Anlage nach Anspruch 5, **dadurch gekennzeichnet,** daß die Erzeugungseinrichtungen (54) das zweite elektrische Potential des Drahtes (14) auf einen Wert von etwa -1 KV einstellen.

7. Anlage nach Anspruch 5, **dadurch gekennzeichnet,** daß Einrichtungen vorgesehen sind, die das erste und das zweite Potential im wesentlichen ausgleichen.

8. Anlage nach einem der vorhergehenden Ansprüche, **dadurch gekennzeichnet,** daß der Draht (14) in seinem mittleren Bereich zum Erhalt einer Biegung (16) umgebogen ist und daß ein Träger (18) zur Beibehaltung des Drahtes (14) in weitgehend vertikaler Ausrichtung um die Biegung (16) herum angeordnet ist.

9. Anlage nach einem der vorhergehenden Ansprüche, **dadurch gekennzeichnet,** daß der Tiegel (12) aus einem Werkstoff besteht, der bei hoher Temperatur einen sehr niedrigen Dampfdruck aufweist.

10. Anlage nach Anspruch 9, **dadurch gekennzeichnet,** daß der Tiegel (12) aus Graphit besteht.

11. Anlage nach einem der vorhergehenden Ansprüche, **dadurch gekennzeichnet,** daß die Zelle (2) Regelungseinrichtungen zur Messung der Temperatur des Werkstoffes, der in dem Tiegel aufgenommen ist, und zur Einwirkung auf die Heizeinrichtungen (50) des Drahtes zu dessen Temperaturregelung umfaßt.

12. Anlage nach Anspruch 11, **dadurch gekennzeichnet,** daß die Regelungseinrichtungen wenigstens ein Thermoelement (21) umfassen, das am Boden des Tiegels (12) befestigt und mit elektrischen Einrichtungen (52) verbunden ist, die auf die Heizeinrichtungen (50) des Drahtes zur Temperaturregelung einwirken.

13. Anlage nach einem der vorhergehenden Ansprüche, **dadurch gekennzeichnet,** daß der untere Teil der Zelle (2) ein erstes Teil (31), welches die erste Vielzahl von Abschirmungen (22) trägt und an welchem eine Stange befestigt ist, die den Tiegel im wesentlichen in der Mitte des oberen Teiles der Zelle hält, ein an dem ersten Teil (31) angebrachtes zweites Teil (32), welches zur Befestigung an der Zelle (2) vorgesehen ist, wobei die Potentialzuführungen der Erzeugungseinrichtungen (54), die Stromzuführungen (20) der Heizeinrichtungen (50) des Drahtes (14) und das Thermoelement (21) durch die beiden Teile (31, 32) mittels elektrisch isolierter Durchgänge hindurchgeführt sind, ein drittes Teil (34), welches mit dem zweiten Teil über zwei Stützen (36) verbunden und auf welchem Einrichtungen (42) zum Ausgleich der Wärmedehnung des Thermoelementes (21) montiert sind, und einen die Zelle (2) mit einer Einfassung (5) unter Vakuum verbindenden Dichtflansch aufweist, und daß außerhalb des unteren Teiles der Zelle (12) die Erzeugungseinrichtungen (54), die Heizeinrichtungen (50) des Drahtes und elektrische Regelkreise (52) angeordnet sind.

## Claims

1. Device for the vacuum evaporation of materials comprising a cylindrical cell (2) which houses in a leaktight manner and substantially in the centre of the upper part thereof an electrically conductive crucible (12) containing the said materials, surrounded by at least one electrically conductive heating filament which can emit electrons at high temperature, the cell (2) further comprising means (50) for heating the filament and means for focusing electrons which can generate a high electric field between the filament and the crucible, characterised in that the focusing means comprise an assembly of adjacent screens (22, 26) disposed inside the cell, surrounding the crucible (12) opposite the side surfaces and the base thereof, as well as at least part of the filament, and subjected to a first negative electrical potential relative to earth to focus the electrons emitted by the filament (14) on the wall of the crucible (12).

2. Device according to Claim 1, characterised in that the crucible (12) is earthed.

3. Device according to either of Claims 1 and 2, characterised in that it further comprises an assembly of remote screens (27) which are placed on the opposite side from the crucible in relation to the assembly of adjacent screens (22, 26), are insulated from the latter and are earthed.

4. Device according to Claim 3, characterised in that the assembly of adjacent screens comprises a first plurality of superimposed screens (22) which are applied against the internal face of the cell (2) and are disposed opposite the side surfaces of the crucible (12), as well as a second plurality of superimposed screens (26) which are secured in the centre of the cell (2) and disposed opposite the base of the crucible (12) whilst the assembly of remote screens comprises a third plurality of superimposed screens (27) which are secured in the centre of the cell (2) and are disposed below the second plurality of screens (26).

5. Device according to any one of the preceding claims, characterised in that the focusing means comprise generator means (54) for applying to the filament a second negative electrical potential relative to earth.

6. Device according to Claim 5, characterised in that the generator means (54) enable the second electrical potential of the filament (14) to be brought to a value of approximately -1 KV.

7. Device according to Claim 5, characterised in that it comprises means enabling the first and second potentials to be substantially equalised.

8. Device according to any one of the preceding claims, characterised in that the filament (14) is curved in its central section so as to form a bend (16); and in that a bracket (18) is placed around the bend (16) in order to hold the filament (14) substantially vertical.

9. Device according to any one of the preceding claims, characterised in that the material constituting the crucible (12) has very low vapour pressure at high temperature.

10. Device according to Claim 9, characterised in that the material forming the crucible (12) is graphite.

11. Device according to any one of the preceding claims, characterised in that the cell (2) further comprises regulating means suitable for measuring the temperature of the material present in the crucible and suitable for acting on the means (50) for heating the filament so as to regulate the said temperature.

12. Device according to Claim 11, characterised in that the regulating means comprise at least one thermo-electric couple (21) mounted on the base of the crucible (12) and connected to electrical means (52) acting on the means (50) for heating the filament so as to regulate the temperature.

13. Device according to any one of the preceding claims, characterised in that the lower part of the cell (2) is formed by a first part (31) which supports the first plurality of screens (22) and on which there is mounted a rod holding the crucible (12) substantially in the centre of the upper part of the cell, a second part (32) which is attached to the first part (31) and serves as a base for the cell (2), the potential supply leads for the generator means (54), the current supply leads (20) for the means (50) for heating the filament (14) and the thermo-electric couple (21) passing respectively through the said parts (31, 32) via electrically insulated passages, a third part (34) which is connected to the second part by means of two columns (36) and on which there are mounted means (42) for compensating the dilation of the thermo-electric couple (21), and a sealed flange (6) which is intended to connect the cell (2) to a vacuum chamber (4) and beyond which there are mounted the generating means (54), means (50) for heating the filament and the electric regulating circuits (52).

# FIG.1

FIG.2

FIG.3